# EUROPEAN PATENT SPECIFICATION

(11) **EP 0 962 550 B1**
(45) Date of publication and mention of the grant of the patent: **16.04.2003**
(21) Application number: 99870102.3
(22) Date of filing: 12.05.1999
(51) Int. Cl.: C23C 16/50, C23C 16/26

(54) **Plasma method for depositing surface layers**
Plamaverfahren zur Herstellung von Oberflächenschichten
Procédé assisté par plasma de depôt de couches minces

(30) Priority: 20.05.1998 BE 9800387
(43) Date of publication of application: 08.12.1999
(73) Proprietor: VLAAMSE INSTELLING VOOR TECHNOLOGISCH ONDERZOEK, afgekort V.I.T.O., onderneming van openbaar nut onder de vorm van een n.v., 2400 Mol (BE)
(72) Inventor: Dekempeneer, Erik, 2390 Oostmalle (BE); Meneve, Jan, 2400 Mol (BE); Smeets, Jos, 2140 Borgerhout (BE)
(74) Representative: Van Malderen, Joelle

(56) References cited:
- DE-C- 19 513 614
- US-A- 5 587 207

## Description

### Subject matter of the invention

The invention relates to the deposition of surface layers with the aid of bipolarly pulsed d.c. plasma.

### Background of the invention

The term "diamond-type layer" is well known in the literature [E. Dekempeneer, J. Meneve and J. Smeets: "diamantachtige filmen voor slijtagetoepassingen" {diamond-like films for wear applications}, published in "Klei, Glas en Keramiek" {Clay, Glass and Ceramic}, Volume 17, 1996, Number 11, pp. 9-13] and is used as a name for a hard, wear-resistant, lubricating and chemically inert carbon layer which is applied via a vacuum process. Various preparation methods are already known: ion beam, plasma and laser techniques. The common characteristic of all these methods is that hard and dense carbon films are obtained by use being made of energetic particles (50-1500 eV) which continuously bombard the surface of the carrying film.

The plasma techniques ("plasma assisted chemical vapour deposition", abbreviated as "PACVD") employ a hydrocarbon gas as a starting material. The hydrocarbon gas is activated at reduced pressure in a reactor chamber by a plasma (glow discharge). As a consequence of this activation, numerous reactive components are produced, inter alia neutral free radicals and electrically charged ions and electrons. These reactive particles result in the deposition of a film on whatever surface is present in the plasma chamber. This film is usually composed of an amorphous network of carbon and hydrogen atoms, these being the elemental building blocks of the starting material (hydrocarbon gas), and is designated in the literature by the abbreviation a-C:H (amorphous hydrogenated hydrocarbon film) .

The various plasma techniques differ in the way in which the plasma is generated. A known standard plasma process for preparing a-C:H layers is r.f. PACVD (radio frequency plasma assisted chemical vapour deposition). Typically, an r.f. frequency of 13.56 MHz is used. The r.f. voltage is generally applied capacitively to that electrode on which the substrates to be covered are positioned. Reactive gas components (free radicals) diffuse to the substrate and form a solid deposit. During the formation of this deposit, the surface is continuously subjected to an energetic ion bombardment. These ions come from the plasma and are accelerated towards the substrate surface by the so-called 'bias voltage'. This bias voltage in fact is a negative d.c. shift of the electrode potential which is due to the difference in mobility between the ions and electrons from the plasma. The bias voltage can be controlled via the total injected r.f. power. Generally it can be assumed that, as the bias voltage increases from 0 to 1500 V, the film characteristics change from polymer-like via diamond-like to graphite-like. The bias voltage window within which hard diamond-like coatings are prepared, varies depending on the choice of the starting material (hydrocarbon gases typically used are methane, acetylene, butane, toluene, benzene) and the pressure at which the deposition is effected (typically between 1 and 50 Pa).

The r.f. PACVD process has a major drawback. The fact is that it is very complicated to maintain r.f. plasmas stably and uniformly on a large scale (> m³ scale). The scale-up of "direct current" d.c. plasmas, in contrast, is much simpler. Results of employing d.c. plasmas for preparing a-C:H films are described in the literature [A. Grill and V.V. Patel: "Diamondlike Carbon Deposited by d.c. PACVD", published in Diamond Films and Technology Vol. 1, No. 4 (1992) pp. 219-233.]. This method, too, has its drawbacks, however, in particular because of the electrically insulating character of a-C:H films. When an insulating coating of sufficient thickness (a few µm) is covering the electrodes, maintaining a d.c. plasma becomes difficult, since the electrical currents can no longer be discharged. At the limit, the insulating film will become charged to such an extent that the plasma is extinguished.

In DE 195 13 614 use is made of a bipolarly pulsed d.c. plasma. "Bipolarly" implies that a negative and a positive voltage pulse are applied alternately. During the negative pulse, positive ions are accelerated towards the substrate, which are important for controlling the characteristics (polymer-like, diamond-like, graphite-like). During the positive voltage pulse the particles sent to the electrode are mainly electrons, which are able to ensure that the positive charging of the insulating film during the preceding negative voltage pulse is compensated for. In this document, use is made of symmetrical bipolar pulses (equal amplitude for positive and negative pulse, as shown in Figure 1 of DE 195 13 614 in a frequency range of from 5 to 100 kHz. A drawback of this method is that there are generally many problems with flashovers (sparks, arcs) at the reactor walls during the positive voltage pulse, certainly if high voltages (during the negative voltage pulse) are required to achieve the desired coating qualities.

### Object of the invention

The object of the invention is to apply a carbon layer having sufficient thickness and high quality to a substrate by means of a bipolarly pulsed d.c. plasma at high voltage and high frequency without flashover occurring at the reactor walls.

### Main characteristics of the invention

The main characteristic of the invention is a method for obtaining a surface layer on a substrate by means of a PACVD plasma generated with the aid of a gas, the substrate being electrically connected to a bipolar voltage source which supplies periodic bipolar voltage pulses, characterized in that the absolute value of the amplitude of the voltage during the positive voltage pulse is much smaller than the absolute value of the amplitude of the voltage during the negative voltage pulse.

The amplitude of the positive voltage pulse is preferably between +50 and +200 volts. The amplitude of the negative voltage pulse is preferably between -50 and -1500 volts.

The pulse frequency, i.e. the frequency at which the bipolar voltage pulse is repeated is between 5 and 250 kHz, preferably between 100 and 250 kHz.

The operating pressure for the gas can vary between 1 and 1000 Pa and is preferably between 10 and 50 Pa.

The surface layer obtained by means of the method according to the invention preferably contains carbon. In this embodiment, the surface layer has a structure such as a polymer-like, a diamond-like layer or a graphite-like layer. The layer obtained depends above all on the amplitude of the negative voltage pulse. The gas for obtaining the plasma preferably contains a hydrocarbon gas. The hydrocarbon gases used in the method according to the invention are preferably chosen from the group consisting of methane, acetylene, butane, toluene, benzene and are diluted with a gas chosen from the group consisting of argon, hydrogen and helium. Other hydrocarbons and gases are also possible.

The positive voltage pulse is preferably shorter than the negative voltage pulse. In other words, the duty cycle (ratio of duration of positive voltage pulse:duration of negative voltage pulse) is preferably smaller than 1, and most preferably smaller than 0.5.

The gas flow rate is preferably chosen such that about 50% of the inflowing hydrocarbon gas is dissociated in the plasma and will thus depend on the total plasma power, the operating pressure and the reactor volume.

Examples of substrates which can be treated by means of the method according to the invention are all types of steel, all non-ferrous metals, hard metal (tungsten carbide), glass and plastics.

### Detailed description of the invention

The present invention proposes the use of an "asymmetrically bipolarly pulsed d.c. plasma" in the frequency range from 5 to 250 kHz, and most preferably from 100 to 250 kHz. In this frequency range, the advantages of, on the one hand, scale-up potential and, on the other hand, adequate plasma density for preparing high-quality coatings are retained. "Asymmetrically" means that the amplitude of the positive pulse is much smaller than that of the negative pulse. Typically, the amplitude of the positive pulse is between +50 and +200 V and is constant and independent of the amplitude of the negative pulse. The amplitude of the negative pulse is freely chosen as a function of the desired coating characteristics and typically varies between -50 and -1500 V.

The length of the positive pulse is set such that the positive surface charge from the preceding negative voltage pulse is adequately compensated for. Usually, the positive voltage pulse is shorter than the negative pulse.

Some of the critical parameters during the deposition of a-C:H films by means of a bipolarly pulsed d.c. plasma process are: pulse frequency, amplitude of the d.c. voltage during the negative voltage pulse (negative peak voltage), ratio of the duration of the positive and negative voltage pulse (duty cycle = ratio positive/negative duration), gas pressure during the deposition, choice of hydrocarbon gas.

The pulse frequency has a major effect on the plasma density and therefore on the ion flux onto the substrate (as the pulse frequency increases, said plasma density increases). A higher frequency allows higher growth rates to be achieved at comparable process pressures and better coating characteristics (greater hardnesses) to be obtained. However, the frequency range chosen still allows the plasmas to be established on a large scale.

The amplitude of the negative voltage pulse, on the other hand, determines the accelerating voltage for the ions towards the substrate (ion energy).

The gas pressure influences said ion energy, because at high gas pressures collisions between the particles will result in the ions losing more energy.

The choice of the hydrocarbon gas is important, because each gas exhibits a different cracking pattern, which means that, for example, the mass of the bombarding ions can vary considerably.

Typical working conditions for the deposition of a-C:H layers with the aid of a bipolarly asymmetrically pulsed d.c. plasma are given in Example 1. The scope of the present patent is not limited, however, to these values.

### Brief description of the Figures:

Figure 1 describes the change of the voltage as a function of time with the method according to the invention.
Figure 2 describes an apparatus in which the method according to the invention can be implemented.

### Example 1:

### Deposition of a-C:H layer with the aid of a bipolarly asymmetrically pulsed d.c. plasma

The process parameters are as follows:
- pulse frequency = 250 kHz,
- amplitude of positive voltage pulse = 50 V,
- duty cycle = 20%,
- hydrocarbon gas = methane,
- methane operating pressure = 10 Pa, and
- gas flow rate = 50 sccm. (sccm = Standard Cubic Centimetre: measured at 760 mm of Hg and 0°C).

The substrates to be covered are placed into the vacuum reactor on the electrode which is connected to the pulsed d.c. supply. After the reactor has been pumped down to the desired background pressure (i.e. the lowest pressure achieved when the vacuum pumps are pumping at maximum capacity and no gas is admitted), methane, at the gas flow rate selected, is passed into the reactor and the pressure is stabilized at the desired operating pressure. Then the plasma is generated by the pulsed d.c. supply being switched on. The value to which the amplitude of the negative voltage pulse is set now determines to a significant extent the characteristics of the deposited film. With amplitudes between 0 and -500 V, the coating is typically very rich in hydrogen and of polymer type. With amplitudes between -500 and -800 V, the coating reaches its highest hardness value (nano indentation hardness values up to 35 GPa, reference silicon = 12 GPa). With amplitudes of even larger negative values than -800 V, the coating becomes graphite-like and softer. These various coating types each have their own physical, chemical, mechanical, optical, electrical and tribological behaviour and are therefore suitable for different applications. All these coatings have a significant hardness, which makes them eligible as wear-resistant layers. The coefficients of friction are typically very low compared with most types of material. Depending on the operating conditions (dry or humid air, vacuum, ...), the coating structures (hydrogen-rich, hard diamond-like, graphite-like) can be optimized to obtain optimal tribological behaviour. Other important controllable coating characteristics are the optical transparency and the electrical conductivity.

These typical operating conditions can be varied in numerous ways. For example, the pulse frequency can be changed. As the pulse frequency decreases, the maximum hardness is achieved at higher and higher negative peak voltages. As a result of the pulse frequency being reduced, for example, to 150 kHz, the maximum hardness will be reached at, typically, -1000 V. The duty cycle can be varied over a very wide range, but is generally chosen to be less than 50%, to ensure an adequate deposition rate. The operating pressure can typically be varied between 1 and 1000 Pa. The gas flow rate is generally tailored to the reactor volume and is typically set to such a value that about 50% of the admitted gas flow is dissociated by the plasma. Apart from methane, numerous other hydrocarbon gases can be chosen. Furthermore, these hydrocarbon gases can additionally be diluted in various other types of gases such as hydrogen, argon, helium and others. Depending on the hydrocarbon gas chosen, the settings of the pulsed d.c. source will be adjusted so as to achieve the desired coating characteristics (polymer-like, diamond-like, graphite-like).

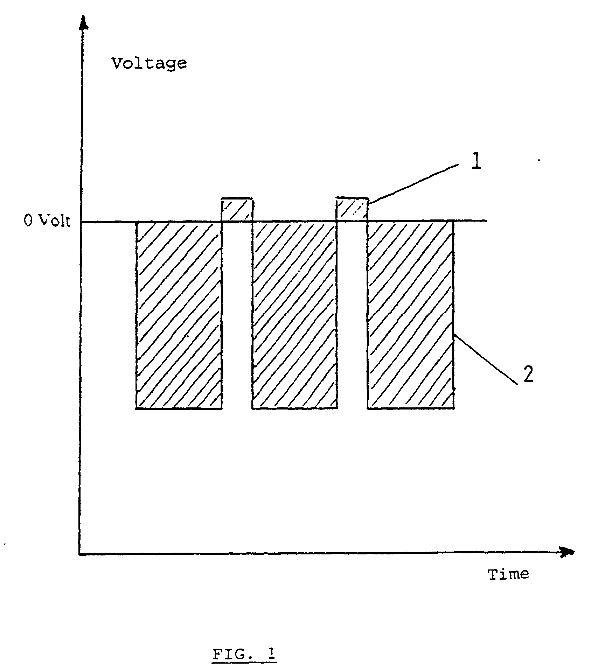

An example of a voltage profile as a function of time is described in Figure 1. One negative (2) and one positive pulse (1) together form a bipolar pulse. In the case of Figure 1, the negative pulse duration is longer than the positive pulse duration, and the absolute value of the amplitude of the negative voltage pulse is larger than the absolute value of the amplitude of the positive voltage pulse.

In addition to the basic embodiment, in which the bipolar pulse d.c. voltage signal is applied as such to an electrode in a vacuum chamber, process gases are admitted at a well defined pressure and a plasma is ignited, supplementary provisions can be made to produce a further increase in the plasma density, for example by installing 'hot filaments' or 'hollow cathodes' to inject electrons into the plasma. Another option is to enclose the plasma in an external magnetic field, as a result of which the path length of electrons in the plasma is extended, so that they will produce a more efficient degree of ionisation. Various magnet configurations are suitable for this purpose. As a result of a higher plasma density, the maximum achievable hardness value increases and is attained at smaller and smaller amplitudes of the negative voltage pulse. This may be advantageous for achieving uniform coverage of dense stacks of complex components.

The entire approach to controlling the process for depositing an a-C:H layer on a substrate is more complex, as a rule, than merely igniting a plasma in a hydrocarbon gas. Depending on the choice of substrate, it may be necessary to make use of adhesion layers to provide good adhesion of the a-C:H layer on the substrate. The Si interlayers which were specifically developed for depositing a-C:H layers on steel by means of r.f. PACVD can also be prepared via the said bipolarly pulsed d.c. plasma technology. Other interlayers such as, for example, modified Si layers obtained by addition of carbon or oxygen elements, or yet others, can likewise be prepared by means of this method. A prior plasma-cleaning step, for example in argon or argon/hydrogen or other gas combinations, which is used virtually as a standard procedure in all vacuum coating processes, and which is meant to effect careful cleaning of the substrate surface before it is covered, can obviously also be carried out by means of the bipolarly pulsed d.c. plasma technology.

The said bipolarly pulsed d.c. plasma technology can also be used to prepare modified a-C:H layers. The modification then involves the incorporation, in the layers, of elements other than carbon and hydrogen by the hydrocarbon gas being admixed with supplementary reactive gases. Thus it is possible, for example, to incorporate nitrogen into the layers by the admixture of nitrogen gas, to incorporate boron by the admixture of diborane gas, to incorporate silicon by the admixture of silane gas. Other modifications are obviously also conceivable (other gases, other elements), and it will be evident that a suitable choice of a specific element will allow the physical, chemical, optical, electrical, mechanical and tribological characteristics of the modified a-C:H layers to be varied at will. Of course it is possible for two or more of the abovementioned layers to be combined into a multilayer structure.

It is to be expected that not only a-C:H layers, optionally modified, but also entirely different layers can be prepared by means of the present bipolarly pulsed d.c. technology. In particular, any layer which can be obtained via r.f. PACVD, can also be prepared by our methods. Examples of such layers are SiₓN_{y}, BₓN_{y}, SiₓO_{y}, CₓF_{y}, CₓSi_{y}O_{z}. Other examples can be found in the literature.

### Example 2:

### Deposition of SiₓN_{y} layers with the aid of a bipolarly asymmetrically pulsed d.c. plasma

SiₓN_{y} layers having a variable composition (0.3 < x/(x+y) < 1) can be prepared by a pulsed d.c. plasma being ignited in a silane (SiH₄) + nitrogen (N₂) gas mixture. By choosing the amplitude of the negative voltage pulse between -200 and -1500 V and by choosing a suitable gas composition in the pressure range 1-1000 Pa it is possible to prepare stoichiometric silicon nitride (Si₃N₄) layers having an optical refractive index which varies between 1.9 and 2.1, and a hardness of about 20 GPa. These layers furthermore have the advantage that they are transparent in the visual range, thus being suitable for protecting glass, plastic and the like in optical applications.

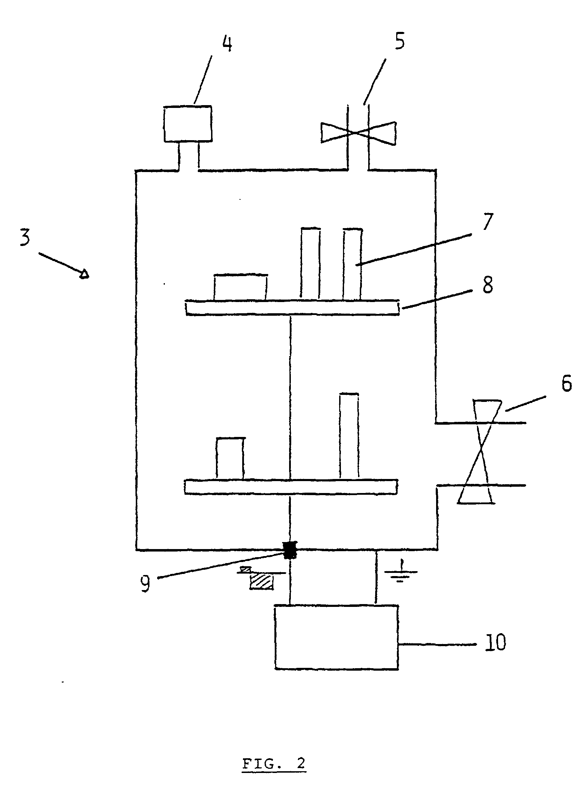

An apparatus in which the method according to the invention can be implemented is depicted in Figure 2. The apparatus (3) comprises a pressure gauge (4), an inlet port for the process gases (5) and a pump outlet (6). The substrates (7) are placed into the apparatus on a substrate holder (8). The bipolarly pulsed voltage is supplied via an electrical lead-through (9) by a bipolarly pulsed d.c. electrical supply (10).

## Claims

1. Method for obtaining a surface layer on a substrate by means of a PACVD plasma generated with the aid of a gas, the substrate being electrically connected to a bipolar voltage source which supplies periodic bipolar voltage pulses, **characterized in that** the absolute value of the amplitude of the voltage during the positive voltage pulse is much smaller than the absolute value of the amplitude of the voltage during the negative voltage pulse.

2. Method as described in claim 1 , **characterized in that** the amplitude of the positive voltage pulse is between +50 and +200 volts.

3. Method as described in claim 1 or 2, **characterized in that** the amplitude of the negative voltage pulse is between -50 and -1500 volts.

4. Method as described in any one of claims 1 to 3, **characterized in that** the frequency at which the bipolar voltage pulse is repeated is between 5 and 250 kHz, preferably between 100 and 250 kHz.

5. Method as described in any one of claims 1 to 4, **characterized in that** the operating pressure of the gas is between 1 and 1000 Pa, preferably between 10 and 50 Pa.

6. Method as described in any one of claims 1 to 5, **characterized in that** the surface layer contains carbon.

7. Method as described in claim 6, **characterized in that** the surface layer has a structure chosen from the group consisting of polymer-like layer, diamond-like layer and graphite-like layer.

8. Method as described in any one of claims 1 to 7, **characterized in that** the gas for obtaining the plasma contains a hydrocarbon gas.

9. Method as described in claim 8, **characterized in that** the hydrocarbon gas is chosen from the group consisting of methane, acetylene, butane, toluene, benzene and is diluted with a gas chosen from the group consisting of argon, hydrogen and helium.

10. Method as described in any one of claims 1 to 9, **characterized in that** the duty cycle is smaller than 1, preferably smaller than 0.5.

## Patentansprüche

1. Verfahren zur Erzeugung einer Oberflächenschicht auf einem Substrat mit Hilfe eines PACVD-Plasmas, das unter Zuhilfenahme eines Gases erzeugt worden ist, wobei das Substrat elektrisch mit einer bipolaren Spannungsquelle verbunden ist, welche periodische bipolare Spannungsimpulse liefert, **dadurch gekennzeichnet, dass** der absolute Wert der Spannungsamplitude während des positiven Spannungsimpulses viel geringer ist als der absolute Wert der Spannungsamplitude während des negativen Spannungsimpulses.

2. Verfahren gemäss Anspruch 1, **dadurch gekennzeichnet, dass** die Amplitude des positiven Spannungsimpulses zwischen +50 und +200 Volt liegt.

3. Verfahren gemäss Anspruch 1 oder 2, **dadurch gekennzeichnet, dass** die Amplitude des negativen Spannungsimpulses zwischen -50 und -1500 Volt liegt.

4. Verfahren gemäss irgendeinem der Ansprüche 1 bis 3, **dadurch gekennzeichnet, dass** die Frequenz, mit welcher der bipolare Spannungsimpuls wiederholt wird, zwischen 5 und 250 kHz, vorzugsweise zwischen 100 und 250 kHz, liegt.

5. Verfahren gemäss irgendeinem der Ansprüche 1 bis 4, **dadurch gekennzeichnet, dass** der Gasbetriebsdruck zwischen 1 und 1000 Pa, vorzugsweise zwischen 10 und 50 Pa, liegt.

6. Verfahren gemäss irgendeinem der Ansprüche 1 bis 5, **dadurch gekennzeichnet, dass** die Oberflächenschicht Kohlenstoff enthält.

7. Verfahren gemäss Anspruch 6, **dadurch gekennzeichnet, dass** die Oberflächenschicht eine Struktur aufweist, die aus der Gruppe bestehend aus einer polymerähnlichen Schicht, einer diamantähnlichen Schicht oder einer graphitähnlichen Schicht ausgewählt wird.

8. Verfahren gemäss irgendeinem der Ansprüche 1 bis 7, **dadurch gekennzeichnet, dass** das zur Erzeugung des Plasmas dienende Gas kohlenwasserstoffhaltiges Gas enthält.

9. Verfahren gemäss Anspruch 8, **dadurch gekennzeichnet, dass** das kohlenwasserstoffhaltige Gas aus der Gruppe bestehend aus Methan, Acetylen, Butan, Toluol, Benzol ausgewählt wird, und dass es mit einem Gas verdünnt wird, das aus der Gruppe bestehend aus Argon, Wasserstoff und Helium ausgewählt wird.

10. Verfahren gemäss irgendeinem der Ansprüche 1 bis 9, **dadurch gekennzeichnet, dass** der Arbeitszyklus geringer ist als 1, vorzugsweise geringer als 0,5.

## Revendications

1. Procédé pour obtenir une couche de surface sur un substrat au moyen d'un plasma PACVD généré à l'aide d'un gaz, le substrat étant connecté électriquement à une source de tension bipolaire qui délivre des impulsions de tension bipolaires périodiques, **caractérisé en ce que** la valeur absolue de l'amplitude de la tension au cours de l'impulsion de tension positive est beaucoup plus petite que la valeur absolue de l'amplitude de la tension au cours de l'impulsion de tension négative.

2. Procédé selon la revendication 1, **caractérisé en ce que** l'amplitude de l'impulsion de tension positive se situe entre +50 et +200 volts.

3. Procédé selon la revendication 1 ou 2, **caractérisé en ce que** l'amplitude de l'impulsion de tension négative se situe entre -50 et -1500 volts.

4. Procédé selon l'une quelconque des revendications 1 à 3, **caractérisé en ce que** la fréquence à laquelle l'impulsion de tension bipolaire est répétée se situe entre 5 et 250 kHz, de préférence entre 100 et 250 kHz.

5. Procédé selon l'une quelconque des revendications 1 à 4, **caractérisé en ce que** la pression de service du gaz se situe entre 1 et 1000 Pa, de préférence entre 10 et 50 Pa.

6. Procédé selon l'une quelconque des revendications 1 à 5, **caractérisé en ce que** la couche de surface contient du carbone.

7. Procédé selon la revendication 6, **caractérisé en ce que** la couche de surface a une structure choisie parmi le groupe constitué d'une couche de type polymère, d'une couche de type diamant et d'une couche de type graphite.

8. Procédé selon l'une quelconque des revendications 1 à 7, **caractérisé en ce que** le gaz pour obtenir le plasma contient un gaz hydrocarboné.

9. Procédé selon la revendication 8, **caractérisé en ce que** le gaz hydrocarboné est choisi parmi le groupe constitué du méthane, de l'acétylène, du butane, du toluène, du benzène et est dilué avec un gaz choisi parmi le groupe constitué de l'argon, de l'hydrogène et de l'hélium.

10. Procédé selon l'une quelconque des revendications 1 à 9, **caractérisé en ce que** le cycle de service est inférieur à 1, de préférence inférieur à 0,5.
